# EUROPEAN PATENT SPECIFICATION

(11) **EP 2 256 883 B1**
(45) Date of publication and mention of the grant of the patent: **23.01.2013**
(21) Application number: 09160361.3
(22) Date of filing: 15.05.2009
(51) Int. Cl.: H02B 1/50

(54) **An electrical cabinet**
Schaltschrank
Armoire électrique

(43) Date of publication of application: 01.12.2010
(73) Proprietor: ABB Oy, 00380 Helsinki (FI)
(72) Inventor: Pallasmaa, Aaro, Juhani, 00150 Helsinki (FI)
(74) Representative: Holmström, Stefan Mikael

(56) References cited:
- DE-A1- 3 933 328
- US-A- 6 005 188
- US-A1- 2003 194 964
- US-A1- 2004 140 114

## Description

### BACKGROUND OF THE INVENTION

### FIELD OF THE INVENTION

This invention relates to an electrical cabinet, and in, particular to condensing problems within such a cabinet.

### DESCRIPTION OF PRIOR ART

Water can cause significant damages to an electrical apparatus. Electrical cabinets are therefore designed, depending on their intended installation site, in a way that ensures that water cannot penetrate into the electrical cabinet and damage the electrical apparatus enclosed therein. However, a phenomenon which is difficult to avoid is condensation. If the temperature of the surroundings, in other words outside the electrical cabinet, is sufficiently much lower than the temperature within the electrical cabinet, then there is a risk of condensation on the inner surfaces of the electrical cabinet. In case of condensation on the inner side of the roof of the electrical cabinet, water may drop down onto the electrical apparatus installed in the electrical cabinet and ultimately damage the electrical apparatus.

Previously there is known from US 2003/0194964 A1 a housing with a ventilation grid in a side wall of the housing. The grid has been dimensioned to prevent insertion of a solid, straight rod having a minimum diameter of 0.8 mm thorough the grid. Consequently such a housing is not suitable for preventing water and dirt from entering the housing. Previously there is also known from US 2004/0140114 A1 a housing for a hearing aids. This housing comprises a fibrous pad covering a perforated cover with capillary openings, that establish a communicating connection between the interior of the hearing-aid housing and the fibrous pad. Such a construction does not prevent water from penetrating to the housing via the cover. US 6005188 discloses an outdoor cabinet with a condensed water discharge device coupled to the roof of the cabinet.

### SUMMARY OF THE INVENTION

An object of the present invention is to solve the above mentioned problem and to provide an electrical cabinet capable of minimizing the risk of damages due to condensation. This object is achieved with an electrical cabinet as defined in independent claim 1.

In the present invention, a roof construction of the electrical cabinet comprises a capillary part with capillary grooves at a location above the electrical apparatus. These capillary grooves are utilized for recovering liquid condensing on a bottom side of the capillary part. Instead of dropping down as water drops onto the electrical apparatus, the condensed water is recovered by sucking it into the capillary grooves due to capillary action.

Preferred embodiments of the invention are disclosed in the dependent claims.

### BRIEF DESCRIPTION OF DRAWINGS

In the following the present invention will be described in closer detail by way of example and with reference to the attached drawings, in which
Figure 1 illustrates a first embodiment of an electrical cabinet,
Figure 2 illustrates the roof construction of the electrical cabinet of Figure 1, and
Figure 3 illustrates a second embodiment of an electrical cabinet.

### DESCRIPTION OF AT LEAST ONE EMBODIMENT

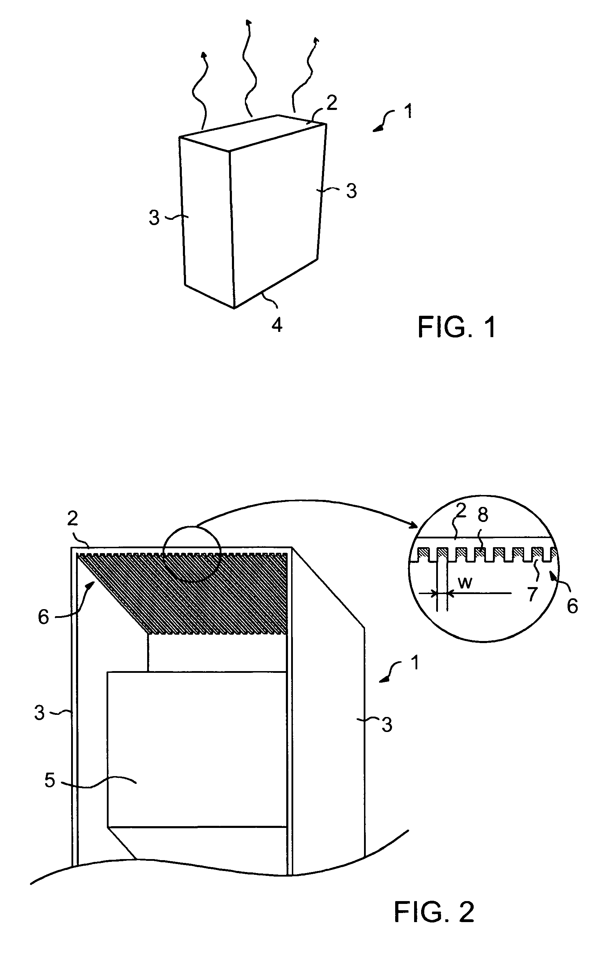

Figures 1 and 2 illustrate a first embodiment of an electrical cabinet 1. Figure 1 illustrates an outside view of the electrical cabinet 1 and Figure 2 a front view where a door is opened or one of the side walls 3 has been removed in order to illustrate the interior of the electrical cabinet.

During use, the roof construction 2, the walls 3 and a bottom 4, respectively, adjoin each other to isolate an electrical apparatus 5 from the surroundings in order to prevent dirt and water from entering the electrical cabinet. Thus the roof construction, walls and bottom restrict free flow of air between the inside and outside of the electrical cabinet. Such an air flow may exist, but the flow is weak when compared to an open electrical cabinet. In case of an electrical cabinet placed on a floor (in a building) or on the ground (outside), a separate bottom is not absolutely necessary, but instead the floor or the ground can act as a bottom of the electrical cabinet.

During use of the electrical apparatus 5, which may consist of power electronics of a frequency converter, for instance, heat is generated into the interior of the electrical cabinet 1. The generated heat raises the temperature of the roof construction 2, walls 3 and bottom 4 of the electrical cabinet 1.

Once the use of the electrical apparatus 5 and the heat generation inside the electrical cabinet 1 end, the temperature of the roof construction 2, walls 3 and bottom 4 begins to drop towards the temperature of the surroundings. If the temperature of the surroundings is sufficiently low, then it is possible that the temperature of the roof construction 2, walls 3 and bottom 4 falls below the dew point of the air inside the electrical cabinet 1, which leads to condensation in the electrical cabinet 1. Such condensation (which may also occur in other situations than the described one) can be very harmful for the electrical apparatus 5, especially if condensation occurs on the inner surface of the roof which is located straight above the electrical apparatus. In that case water drops may end up falling directly towards the electrical apparatus 5.

In order to avoid such negative effects of condensation at least directly above the electrical apparatus 5, at least the roof construction 2 comprises a first capillary part 6 located above the electrical apparatus. In the embodiment of Figures 1 and 2, the first capillary part 6 is integrated into a flat plate that acts as the roof of the electrical cabinet. Alternatively, it is possible to arrange a capillary part 6 as an additional element towards the inner surface of the roof. The roof with an integral capillary part or a separate capillary part can be manufactured of aluminum by extrusion, for instance.

The first capillary part 6 comprises, on a bottom side facing the electrical apparatus 5, capillary grooves 7 for recovering liquid, in this case water, condensing on the bottom side of the capillary part 6. Instead of dropping down as water drops onto the electrical apparatus 5, the condensed water 8 is recovered by sucking it into the capillary grooves due to capillary effect or capillary action. In the illustrated example, the capillary part is provided with capillary grooves 7 having a width W, which is smaller than 1 mm to 0.5 mm. In praxis it has been shown that the capillary action is strong when the width of the grooves W is 0.4 mm and the depth of the grooves is 0.4 mm. It has also been shown that the capillary action is strong when the width of the grooves W is 0.34 mm and the depth of the grooves is 0.8 mm. It is also possible to use even smaller dimensions, such as 0.12 mm as the width of the grooves, 0.24 as the depth of the grooves and 0.04 mm as the interval between the grooves. However, it should be observed that these dimensions are only examples of suitable dimensioning, while within the scope of the invention also other dimensions can be used.

Normally, the amount of water 8 recovered by the capillary grooves 7 should be small enough to remain in the capillary grooves 7 until the electrical apparatus 5 is taken into use for a next working cycle. At that stage the heat generated by the electrical apparatus 5 evaporates the water such that the capillary grooves are dried up by the air inside the electrical cabinet. However, to ensure that the capillary grooves 7 are not overfilled at any stage, which increases the risk of water dropping down onto the electrical apparatus 5, the capillary part 6 can be arranged in a position where it forms a small angle with the horizontal plane. Thus, the water can flow along the capillary part 6 towards the lowest part of the capillary part 6, preferably close to a selected wall, from where it can be led forward by suitable channels out of the electrical cabinet, for instance. In this way, excess water can be led away without damaging the electrical apparatus 5.

The use of the above-described first capillary part 6 is most advantageous for an electrical cabinet 1 used in an outdoor installation, where the electrical apparatus 5 enclosed by the electrical cabinet 1 is working periodically, though advantages can be achieved also in connection with other electrical cabinets. In this context a periodically working apparatus refers to an apparatus which is in use during certain periods of time and out of use during other periods of time. In outdoor installations temperature differences may be very large, especially in the night-time. If the use of a periodically used electrical apparatus 5 in such an outdoor electrical cabinet is ended during the night, then an excessive temperature drop can be anticipated, which will eventually lead to condensation in the electrical cabinet 1.

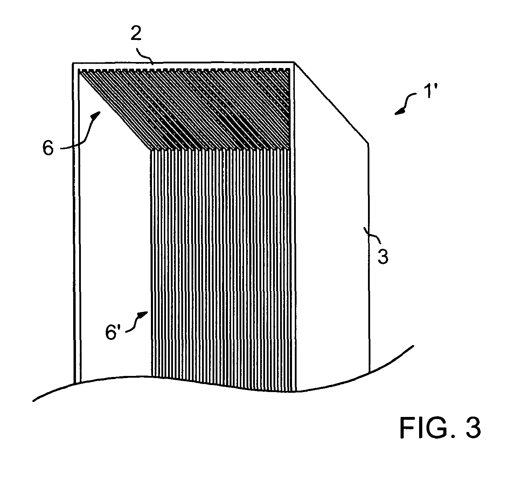

Figure 3 illustrates a second embodiment of an electrical cabinet 1'. The embodiment of Figure 3 is very similar to the one explained in connection with Figures 1 and 2. Therefore, the embodiment of Figure 3 will be explained in the following mainly by pointing out the differences between these embodiments.

In addition to the first capillary part 6 located in the roof construction 2 of the electrical cabinet 1', the electrical cabinet 1' comprises at least one second capillary part 6'. The second capillary part 6' is arranged in a wall construction of a wall 3 of the electrical cabinet 1' and it comprises capillary grooves similar to those explained in connection with the first capillary part 6. The second capillary part 6' increases the capability of the electrical cabinet 1' of recovering liquid condensing in the electrical cabinet, and therefore more than one such second capillary part 6' can be utilized in the electrical cabinet in connection with the walls 3, for instance.

Similarly to what was explained regarding the first capillary part 6, the second capillary part 6' can be integrated into a wall, or alternatively accomplished by arranging a separate second capillary part 6' against an inner surface of a wall 3, for instance.

It is to be understood that the above description and the accompanying figures are only intended to illustrate the present invention. It will be obvious to a person skilled in the art that the invention can be varied and modified without departing from the scope of the invention.

## Claims

1. An electrical cabinet (1, 1') for receiving and enclosing an electrical apparatus (5) such that said electrical apparatus is isolated from the surroundings by said electrical cabinet (5),
said electrical cabinet (1, 1') is an electrical cabinet for outdoor installation,
a roof construction (2), walls (3) and a bottom (4), respectively, of the electrical cabinet adjoin each other to prevent dirt and water from entering the electrical cabinet (1, 1'), **characterized in that**
the roof construction (2) of said electrical cabinet (1, 1') comprises at least a first capillary part (6) located above said electrical apparatus (5), and
said first capillary part (6) comprises capillary grooves (7) for recovering liquid condensing on said first capillary part (6).

2. An electrical cabinet according to claim 1, **characterized in that** said first capillary part (6) consists of one or more plates which form a roof of the electrical cabinet (1, 1').

3. An electrical cabinet according to claim 1 or 2, **characterized in that** said electrical apparatus (5) is a periodically operating electrical apparatus generating heat into an interior of said electrical cabinet (1, 1') while in use.

4. An electrical cabinet according to one of the previous claims, **characterized in that** said electrical cabinet (1') comprises at least one second capillary part (6') in a wall construction of said electrical cabinet, said second capillary part (6') comprising capillary grooves (7) on a side facing said electrical apparatus (5) for recovering liquid condensing on said side.

5. An electrical cabinet according to one of the previous claims, **characterized in that** said capillary grooves (7) have a width (w) which is smaller than 1 mm.

6. An electrical cabinet according to one of the previous claims, **characterized in that** said capillary grooves (7) have a width (w) which is smaller than 0.5 mm.

7. An electrical cabinet according to one of the previous claims, **characterized in that** the depth of the capillary grooves (7) is 0.2 mm to 1.0 mm.

## Patentansprüche

1. Schaltschrank (1, 1') zum Aufnehmen und Umgeben eines elektrischen Geräts (5), so dass das besagte elektrische Gerät durch den besagten Schaltschrank (5) von der Umgebung isoliert wird,
der besagte Schaltschrank (1, 1') ein Schaltschrank für Aussenmontage ist,
jeweils eine Dachkonstruktion (2), Wände (3) und ein Boden (4) des Schaltschranks aneinander grenzen, um das Eindringen von Schmutz und Wasser in den Schaltschrank (1, 1') zu verhindern, **dadurch gekennzeichnet, dass**
die Dachkonstruktion (2) des besagten Schaltschranks (1, 1') zumindest ein erstes Kapillarteil (6) aufweist, das sich oberhalb des besagten elektrischen Geräts (5) befindet, und
das besagte erste Kapillarteil (6) Kapillarrillen (7) zur Rückgewinnung von auf dem besagten ersten Kapillarteil (6) verdichteter Flüssigkeit aufweist.

2. Schaltschrank nach Anspruch 1, **dadurch gekennzeichnet, dass** das besagte erste Kapillarteil (6) aus einer oder mehreren Platten besteht, die ein Dach des Schaltschranks (1, 1') bilden.

3. Schaltschrank nach Anspruch 1 oder 2, **dadurch gekennzeichnet, dass** das besagte elektrische Gerät (5) ein periodisch arbeitendes elektrisches Gerät ist, das während des Betriebes Wärme ins Innere des besagten Schaltschranks (1, 1') erzeugt.

4. Schaltschrank nach einem der vorhergehenden Ansprüche, **dadurch gekennzeichnet, dass** der besagte Schaltschrank (1') zumindest ein zweites Kapillarteil (6') an einer Wandkonstruktion des besagten Schaltschranks aufweist, welches zweite Kapillarteil (6') Kapillarrillen (7) auf einer dem besagten elektrischen Gerät (5) zugewandten Seite zur Rückgewinnung von auf dem besagten Seite verdichteter Flüssigkeit aufweist.

5. Schaltschrank nach einem der vorhergehenden Ansprüche, **dadurch gekennzeichnet, dass** die besagten Kapillarrillen (7) eine Breite (w) aufweisen, die kleiner als 1 mm ist.

6. Schaltschrank nach einem der vorhergehenden Ansprüche, **dadurch gekennzeichnet, dass** die besagten Kapillarrillen (7) eine Breite (w) aufweisen, die kleiner als 0,5 mm ist.

7. Schaltschrank nach einem der vorhergehenden Ansprüche, **dadurch gekennzeichnet, dass** die Tiefe der Kapillarrillen (7) 0,2 mm bis 1,0 mm beträgt.

## Revendications

1. Armoire électrique (1, 1') pour recevoir et enfermer un appareil électrique (5) de telle sorte que ledit appareil électrique soit isolé de l'environnement par ladite armoire électrique (5),
ladite armoire électrique (1, 1') étant une armoire électrique pour installation à l'extérieur,
une structure de toiture (2), des parois (3) et un fond (4), respectivement, de l'armoire électrique étant mutuellement adjacents pour empêcher la poussière et l'eau de pénétrer dans l'armoire électrique (1, 1'), **caractérisée en ce que**
la structure de toiture (2) de ladite armoire électrique (1, 1') comprend au moins une première partie capillaire (5) située au-dessus dudit appareil électrique (5), et
ladite première partie capillaire (6) comprend des rainures capillaires (7) pour récupérer le liquide se condensant sur ladite première partie capillaire (6).

2. Armoire électrique suivant la revendication 1, **caractérisée en ce que** ladite première partie capillaire (6) consiste en une ou plusieurs plaques qui forment une toiture de l'armoire électrique (1, 1').

3. Armoire électrique suivant la revendication 1 ou 2, **caractérisée en ce que** ledit appareil électrique (5) est un appareil électrique fonctionnant périodiquement, engendrant de la chaleur à l'intérieur de ladite armoire électrique (1, 1') lors de son utilisation.

4. Armoire électrique suivant l'une des revendications précédentes, ladite armoire électrique (1') étant **caractérisée en ce qu'**elle comprend au moins une seconde partie capillaire (6') dans une structure de paroi de ladite armoire électrique, ladite seconde partie capillaire (6') comprenant des rainures capillaires (7) sur un côté tourné vers ledit appareil électrique (5) pour récupérer le liquide se condensant sur ledit côté.

5. Armoire électrique suivant l'une des revendications précédentes, **caractérisée en ce que** lesdites rainures capillaires (7) ont une largeur (1) qui est inférieure à 1 mm.

6. Armoire électrique suivant l'une des revendications précédentes, **caractérisée en ce que** lesdites rainures capillaires (7) ont une largeur (1) qui est inférieure à 0,5 mm.

7. Armoire électrique suivant l'une des revendications précédentes, **caractérisée en ce que** la profondeur des rainures capillaires (7) va de 0,2 mm à 1,0 mm.
